# EUROPEAN PATENT APPLICATION

(11) **EP 2 706 580 A2**
(43) Date of publication of application: **12.03.2014**
(21) Application number: 13162381.1
(22) Date of filing: 04.04.2013
(51) Int. Cl.: H01L 31/05

(54) **Photoelectric device module and manufacturing method thereof**

(30) Priority: 11.09.2012 US 201261699685 P; 14.03.2013 US 201313829224
(71) Applicant: SAMSUNG SDI CO., LTD., Yongin-si, Gyeonggi-do (KR)
(72) Inventor: Yang, Jung-Yup, Gyeonggi-do (KR); Ahn, Young-Kyoung, Gyeonggi-do (KR); Kim, Min-Gu, Gyeonggi-do (KR); Lee, Jun-Young, Gyeonggi-do (KR); Park, Min, Gyeonggi-do (KR); Huh, Pil-Ho, Gyeonggi-do (KR); Kang, Yeon-Il, Gyeonggi-do (KR); Cho, Hyun-Young, Gyeonggi-do (KR)
(74) Representative: Mounteney, Simon James

(57) **Abstract**

A photoelectric converting cell module according to the present invention includes photoelectric converting cells, interconnect wiring, and a bus bar, wherein the interconnect wiring is attached by a conductive adhesive layer, and the bus bar is attached by an insulating adhesive layer. A method for manufacturing the solar cell module includes attaching the interconnect wiring and the bus bar by the conductive adhesive layer and the insulating adhesive layer, and according to the method, a solar cell module with excellent characteristics can be manufactured through a simple and inexpensive method.

## Description

### BACKGROUND

### 1. Field

The described technology relates generally to a photoelectric converting cell module and a manufacturing method thereof.

### 2. Description of the Related Art

A solar cell is a photovoltaic conversion device for converting light energy of the sun into electrical energy by using the photovoltaic effect. In general, a solar cell module (or photoelectric converting cell module) used for a sunlight electric generator system is an electric device that includes a plurality of photoelectric converting cells coupled in series. A current generated by the electrically connected photoelectric converting cells is collected by the module wiring formed on the solar cell module and is then transmitted to a junction box. The above information disclosed in this Background section is only for enhancement of understanding of the background of the described technology and therefore it may contain information that does not form the prior art that is already known in this country to a person of ordinary skill in the art.

### SUMMARY

The described technology has been made in an effort to provide a photoelectric converting cell module for preventing current leakage, providing excellent durability, and allowing an excellent effect with a low cost through a simple and easy process, and a manufacturing method thereof.

According to the method for manufacturing the photoelectric converting cell module of the present embodiment, the photoelectric converting cell module for generating an excellent effect with a low cost by using a simple and easy process can be manufactured.

Further, according to the present embodiment, a photoelectric converting cell module without current leakage and with excellent durability is acquired.

According to an aspect of the present invention, there is provided a photoelectric converting cell module according to Claim 1. Preferred features of this aspect are set out in Claims 2 to 10. According to a further aspect of the present invention, there is provided a method of manufacturing a photoelectric converting cell module of the current invention according to Claim 11. Preferred embodiments of this aspect are set out in Claims 12 to 15.

### BRIEF DESCRIPTION OF THE DRAWINGS

FIG. 1 shows a top plan view of a photoelectric converting cell module according to an embodiment.
FIG. 2 shows a cross-sectional view with respect to a line II-II of FIG. 1.
FIG. 3 shows a cross-sectional view with respect to a line III-IIT of FIG. 1.
FIG. 4 shows a cross-sectional view with respect to a line IV-IV of FIG. 1.
FIG. 5 shows a graph for a damp heat test result according to an embodiment.
FIG. 6A to 6F show a method for manufacturing a solar cell module according to an embodiment, magnifying a part VI of FIG. 1.
FIG. 7 is a flow chart illustrating the process of a method for fabricating a photoelectric converting cell module according to an embodiment.

### DETAILED DESCRIPTION

The present invention will be described more fully hereinafter with reference to the accompanying drawings, in which embodiments of the invention are shown. As those skilled in the art would realize, the described embodiments may be modified in various different ways, all without departing from the scope of the presently claimed invention.

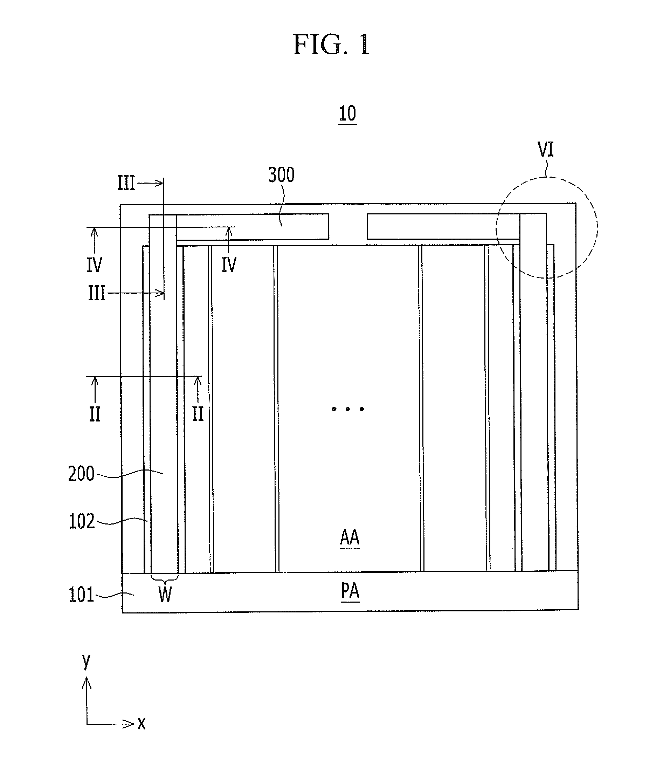

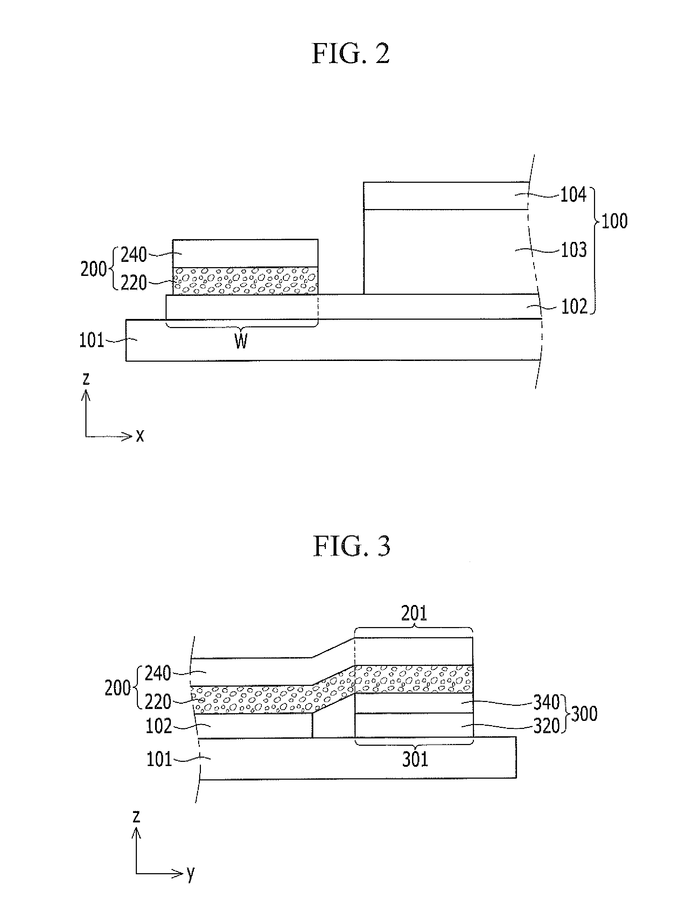

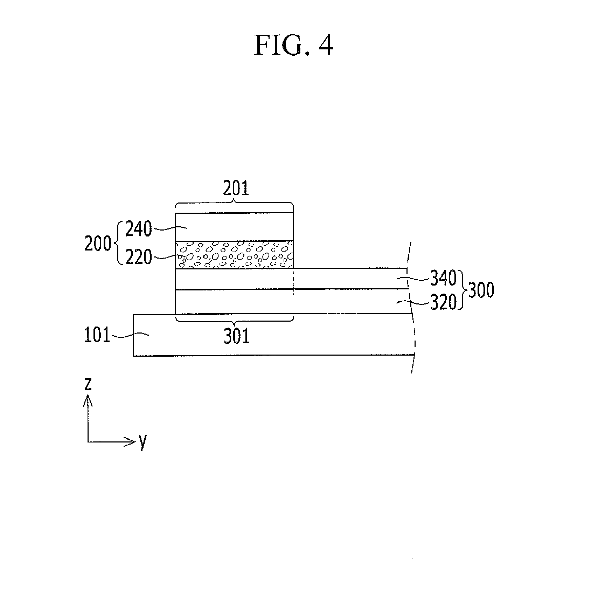

FIG. 1 shows a top plan view of a photoelectric converting cell module according to an embodiment, FIG. 2 shows a cross-sectional view with respect to a line II-II of FIG. 1, FIG. 3 shows a cross-sectional view with respect to a line III-III of FIG. 1, and FIG. 4 shows a cross-sectional view with respect to a line IV-IV of FIG. 1.

Referring to FIG. 1 to FIG. 3, the photoelectric converting cell module 10 includes a substrate 101, a plurality of photoelectric converting cells 100, interconnect wiring 200, and a bus bar 300.

The substrate 101 includes an active area (AA) in which a plurality of photoelectric converting cells 100 are formed, and a periphery area (PA) which surrounds the active area (AA) and in which the bus bar 300 is formed. The substrate 101 can be formed with various materials including plate-type glass, ceramic, stainless steel, metal, or film-type polymers.

The photoelectric converting cell 100 is formed in the active area (AA). The photoelectric converting cells 100 is extended in a first direction (y-axis direction of FIG. 1) of the substrate 101, and is coupled in series in a second direction (x-axis direction of FIG. 1) crossing the first direction. The photoelectric converting cell 100 includes a rear electrode layer 102, a light absorbing layer (or photoelectric converting layer) 103, and a transparent electrode layer 104 disposed on the substrate 101.

The rear electrode layer 102 is provided on the substrate 101. The rear electrode layer 102 is made of a metal with excellent optical reflective efficiency and excellent adhesion to the substrate 101. For example, the rear electrode layer 102 includes molybdenum (Mo). The molybdenum (Mo) has high electrical conductivity, forms an ohmic contact with the photoelectric converting layer 103, and realizes great stability during a high temperature heat treatment for forming the photoelectric converting layer 103.

The photoelectric converting layer 103 is provided over the rear electrode layer 102. The photoelectric converting layer 103 is made of one of silicon and a compound semiconductor. For example, the photoelectric converting layer 103 has a semiconductor pn junction or a pin junction structure. Therefore, the photoelectric converting layer 103 includes a p-type semiconductor layer and an n-type semiconductor layer, and an intrinsic semiconductor layer is inserted between the p-type semiconductor layer and the n-type semiconductor layer. Also, when the photoelectric converting layer 103 is made of a compound semiconductor, it is formed with at least one material of CIGS, CIS, CGS, and CdTe. For example, the photoelectric converting layer 103 is formed with at least one material selected from the group of CdTe, CuInSe₂, Cu(In,Ga)Se₂, Cu(In,Ga)(Se,S)₂, Ag(InGa)Se₂, Cu(In,Al)Se₂, and CuGaSe₂.

The transparent electrode layer 104 is provided over the photoelectric converting layer 103. The transparent electrode layer 104 is formed with a metal oxide including boron doped zinc oxide (BZO), zinc oxide (ZnO), indium oxide (In₂O₃), and indium tin oxide (ITO) with excellent light transmittance. The transparent electrode layer 104 has great electrical conductivity and great light transmittance.

The current generated by the photoelectric converting cell 100 is collected by the interconnect wiring 200. The interconnect wiring 200 is electrically connected to the photoelectric converting cell 100 formed in the outermost region of the active area (AA). Referring to FIG. 2, for a connection to the interconnect wiring 200, a wiring connector (W) formed by partially exposing the rear electrode layer 102 is formed on the photoelectric converting cell 100 formed in the outermost region.

The interconnect wiring 200 includes a wiring metal layer 240 for collecting the current, and a conductive adhesive layer 220 for adhering the wiring metal layer 240 to the wiring connector (W) of the rear electrode layer 102 and turning them on. That is, the interconnect wiring 200 is a conductive metal tape including the conductive adhesive layer 220. Depending on the cases, the interconnect wiring 200 further includes a black cover layer (not shown) made of a black polyethylene terephthalate (PET) film on the wiring metal layer 240 for the purpose of improving the outer appearance.

The wiring metal layer 240 is a metal foil or a metal ribbon made of copper (Cu), copper (Cu)/tin (Sn), aluminum (Al), lead (Pb), silver (Ag), or an alloy thereof. A thickness of the wiring metal layer 240 is between 30 to 400µm. The wiring metal layer 240 is thicker than 30µm in order to secure electric conductivity, and a thicker wiring metal layer 240 is preferred so as to prevent power loss, although the thickness of the wiring metal layer 240 is 400µm or less. When the wiring metal layer 240 is thicker than 400µm, only the costs are increased without any further improvement to power loss.

The conductive adhesive layer 220 includes conductive particles, and an adhesive in which the conductive particle are spread. The conductive particles are metal particles including at least one of copper (Cu), silver (Ag), gold (Au), iron (Fe), nickel (Ni), lead (Pb), zinc (Zn), cobalt (Co), titanium (Ti), and magnesium (Mg), or plating particles caused by them. The conductive particles have a diameter of 10nm-100000nm regarding acquisition of conductivity and maintenance of adhesiveness. When the diameter of a conductive particle is less than 10nm, it is difficult to acquire sufficient conductivity, but when the diameter of the conductive particle is larger than 100000nm, the adhesiveness of the conductive adhesive layer 220 is weak. The adhesive in which the conductive particles are spread is an adhesive layer made of a resin including an acryl-based resin, an epoxy-based resin, a butyl-based resin, ethylvinyl acetate (EVA), polyvinyl butyral (PVB), silicon (Si), ionomer, or polyoxy ethylene (POE).

A thickness of the conductive adhesive layer 220 is set considering adhesiveness between the rear electrode layer 102 and the wiring metal layer 240, and contact resistance. For example, the thickness of the conductive adhesive layer 220 is from 1µm to 500µm. When the conductive adhesive layer 220 is thinner than 1µm, the adhesiveness between the rear electrode layer 102 and the wiring metal layer 240 is weak. However, when the conductive adhesive layer 220 is thicker than 500µm, the contact resistance between the rear electrode layer 102 and the wiring metal layer 240 is increased.

The interconnect wiring 200 is adhered to the wiring connector (W) by the conductive adhesive layer 220. That is, the interconnect wiring 200 is adhered to a top of the rear electrode layer 102 exposed in the first direction (y-axis direction of FIG. 1) of the photoelectric converting cell 100 formed in the outermost region of the active area (AA). The current generated by the photoelectric converting cell 100 is collected through the rear electrode layer 102, the conductive adhesive layer 220, and the interconnect wiring 200. When the interconnect wiring 200 is configured with the wiring metal layer 240 and the conductive adhesive layer 220 for adhering it, the module wiring for collecting the current is easily formed by adhering the metal tape type of interconnect wiring 200 to the wiring connector (W) without a conventional soldering or welding process.

Referring to FIG. 1 and FIG. 3, the interconnect wiring 200 includes an extended portion 201 further extended in the first direction (y-axis direction of FIG. 1) of the photoelectric converting cell 100 to reach the periphery area (PA). The extended portion 201 is electrically connected to the bus bar 300 formed in the periphery area (PA). According to this, the current collected to the interconnect wiring 200 is transmitted to the bus bar 300, and it is then transmitted to a junction box (not shown) formed outside the photoelectric converting cell module 10 through the bus bar 300.

The bus bar 300 includes a bus bar metal layer 340 and an insulating adhesive layer 320 for adhering the bus bar metal layer 340 to the substrate 101. That is, the bus bar 300 is an insulating metal tape including the insulating adhesive layer 320.

The bus bar metal layer 340 is a metal foil or a metal ribbon made of copper (Cu), copper (Cu)/tin (Sn), aluminum (Al), lead (Pb), silver (Ag), or an alloy thereof. The insulating adhesive layer 320 is an adhesive layer made of resin including an acryl-based resin, an epoxy-based resin, a butyl-based resin, ethylvinyl acetate (EVA), polyvinyl butyral (PVB), silicon (Si), an ionomer, and polyoxy ethylene (POE). The thickness of the insulating adhesive layer 320 is appropriately selected by considering prevention of generation of a leakage current and a step caused by coupling with other components. That is, the insulating adhesive layer 320 is substantially thicker than 1µm so as to sufficiently insulate a space between the bus bar metal layer 340 and the substrate 101 and prevent a current leakage. Also, it is thinner than 500µm in consideration of the interconnect wiring 200 and a sealing member (not shown).

The bus bar metal layer 340 is adhered to the periphery area (PA) of the substrate 101 by the insulating adhesive layer 320. Therefore, when the current flows to the bus bar metal layer 340, the leakage of current to the substrate 101 is prevented. The bus bar 300 includes an overlapped portion 301 overlapped on the extended portion 201 of the interconnect wiring 200 and formed on a first end of the bus bar 300. That is, the conductive adhesive portion 220 of the extended portion 201 is adhered to the bus bar metal layer 340 of the overlapped portion 301. Accordingly, the current collected to the interconnect wiring 200 is transmitted to the bus bar metal layer 340 through the conductive adhesive portion 220 and is then transmitted to an external junction box (not shown) through the bus bar 300.

As described, by configuring the bus bar 300 with the bus bar metal layer 340 and the insulating adhesive layer 320 for adhering it on the substrate 101, a bus bar 300 that generates no leakage of current can be formed without an additional insulation process.

Also, according to the present embodiment, by configuring the adhesive layer of the interconnect wiring 200 with the conductive adhesive layer 220 and the adhesive layer of the bus bar 300 with the insulating adhesive layer 320, conductivity of the interconnect wiring 200 is acquired (i.e., resistance is reduced) and the generation of leakage current by the bus bar 300 is prevented.

Referring to FIG. 4, the insulating adhesive layer 320, the bus bar metal layer 340, the conductive adhesive layer 220, and the wiring metal layer 240 are sequentially stacked on a region in which the extended portion 201 of the interconnect wiring 200 is overlapped with the overlapped portion 301 of the bus bar 300. Accordingly, the interconnect wiring 200 and the bus bar 300 are electrically connected to each other, and the bus bar 300 is sufficiently insulated from the substrate 101. That is, the bus bar 300 can be formed by a simple process, and insulated from the substrate 101 without further processing at the same time, so as to prevent generation of the leakage current, since the bus bar 300 is attached to the substrate 101 by the insulating adhesive layer 320. Further, the interconnect wiring 200 can be formed by a simple process, and electrically connected to the rear electrode layer 102 and the bus bar 300 without further processing at the same time, since the interconnect wiring 200 is attached to the rear electrode layer 102 and the bus bar 300 by the conductive adhesive layer 220.

Conventionally, both of the interconnect wiring 200 and the bus bar 300 are formed by a conductive metal tape, so as to form the module wirings by a simple process without a soldering or welding process. In this case, however, the leakage current is generated from the bus bar 300. Thus, in order to solve this problem, extra insulating tape must be formed between the bus bar 300 and the substrate 101, so that the additional process attaches the extra insulating tape which increases the entire thickness. On the other hand, according to the present embodiment, as described above, the interconnect wiring 200 and the bus bar 300 can be formed by a simple process, and at the same time, the generation of the leakage current can be prevented without any extra insulating tape.

Also, according to the present embodiment, if needed, each of the thickness of the adhesive layers 220 and 320 can be appropriately adjusted without increasing the entire thickness of the region overlapping the extended portion 201 and the overlapped portion 301. For example, when the insulating adhesive layer 320 is thick (e.g., thicker than about 300µm), thereby providing sufficient insulation between the substrate 101 and the bus bar metal layer 340, the conductive adhesive layer 220 can be thinner (e.g., thinner than about 100µm) to compensate the increasing thickness of the insulating adhesive layer 320. In this case, the bus bar metal layer 340 is sufficiently insulated from the substrate 101, so that the generation of the leakage current can be prevented without increasing the entire thickness of the region overlapping the interconnect wiring 200 and the bus bar 300. Also, the contact resistance of the interconnect wiring 200 can be decreased by decreasing the transfer distance of electrons through the conductive adhesive layer 220, since the thickness of the conductive adhesive layer 220 is decreased.

Further, the interconnect wiring 200 is adhered by the conductive adhesive layer 220 including the conductive particles, so relatively uniform contact resistance is maintained without much influence by external moisture and heat.

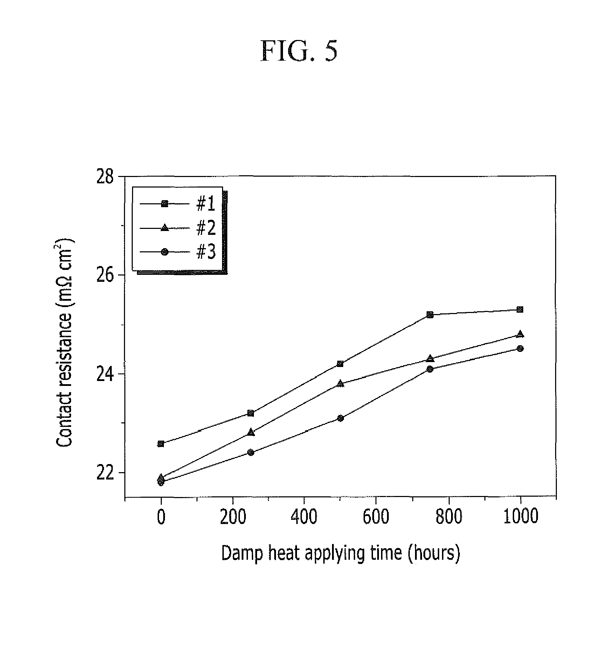

FIG. 5 shows a graph for a damp heat test result for a photoelectric converting cell module 10 according to an embodiment. The photoelectric converting cell module 10 is left alone for about 1000 hours at a 85 °C temperature in an 85 % moisture condition, and a charge of the contact resistance is measured. In FIG. 5, #1, #2, and #3 show results acquired by performing the same test and measuring it three times. As shown in FIG. 5, regarding the photoelectric converting cell module 10 according to the present embodiment, it is found that the change of the contact resistance is about 2 mΩ/cm² after the damp heat test given for 1000 hours so the change is not much. However, when the interconnect wiring 200 is formed with silver paste in the same condition as the present embodiment, the contact resistance is increased up to 80 mΩ/cm² from the contact resistance of 15 mΩ/cm² after 1000 hours. That is, according to the present embodiment, the conductive adhesive layer 220 has a structure for protecting the conductive particles by the adhesive layer so it can have excellent reliability against external heat and moisture.

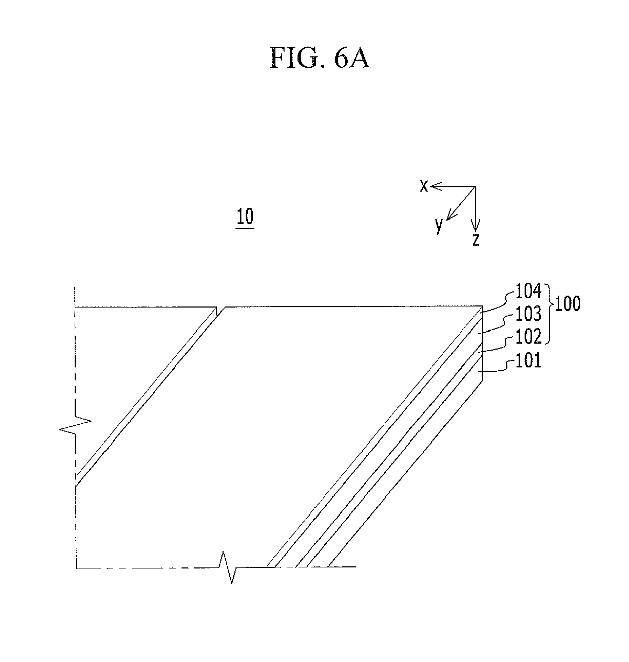

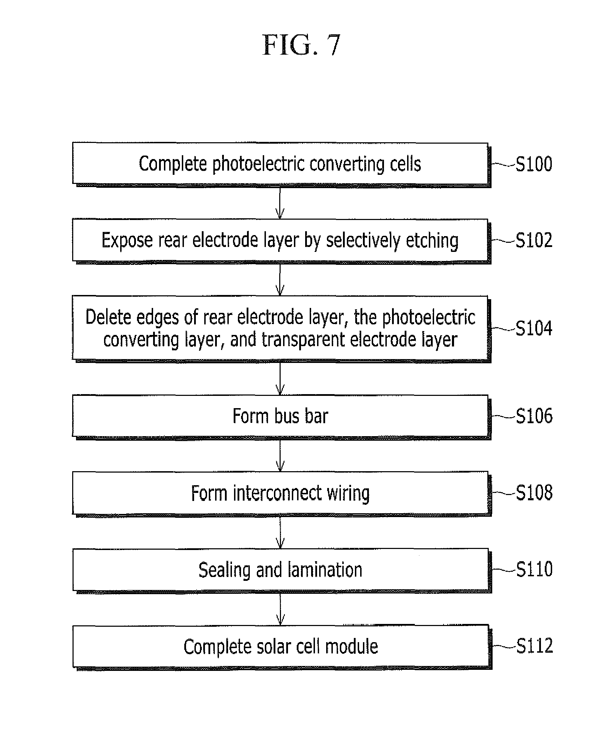

A method for manufacturing a photoelectric converting cell module 10 according to an embodiments will now be described with reference to FIG. 6A to FIG. 6F, and FIG. 7. FIG. 6A to 6F show a method for manufacturing a photoelectric converting cell module according to an embodiment, magnifying a part V of FIG. 1, and FIG. 7 is a flow chart illustrating the process of a method for fabricating a photoelectric converting cell module according to an embodiment.

As shown in FIG. 6A, a rear electrode layer 102, a photoelectric converting layer 103, and a transparent electrode layer 104 are sequentially stacked on the substrate 101 and patterned to form a plurality of photoelectric converting cells 100 (S100).

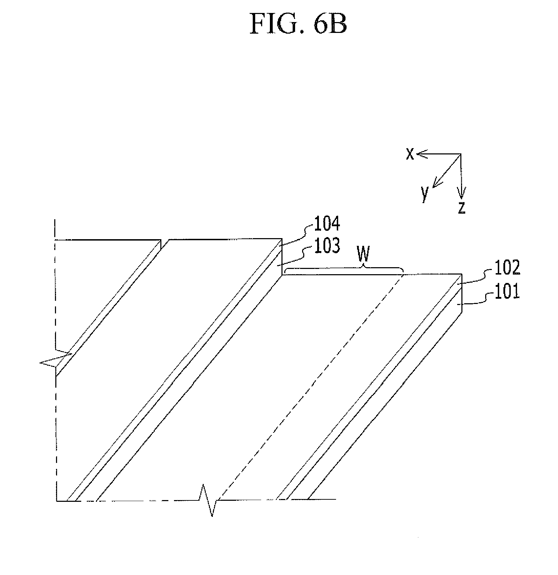

As shown in FIG. 6B, the photoelectric converting layer 103 and the transparent electrode layer 104 of the photoelectric converting cell 100 formed in the outermost region are selectively etched to expose the rear electrode layer 102 (S102). The exposed rear electrode layer 102 includes a wiring connector (W) to which the interconnect wiring 200 is adhered. The selecting etching process is performed by at least one of the laser scribing method mechanical deletion, wet etching, or paste etching.

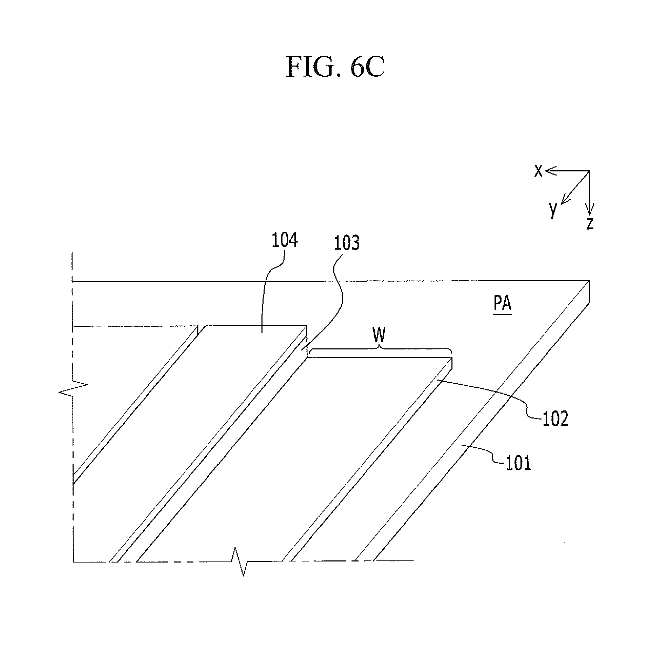

As shown in FIG. 6C, the edges of the rear electrode layer 102, the photoelectric converting layer 103, and the transparent electrode layer 104 are deleted along an edge of the substrate 101 to expose the substrate 101 (S104). The deleted portions correspond to the periphery area (PA). The deletion process is performed by at least one of the laser scribing method mechanical deletion, wet etching, or paste etching.

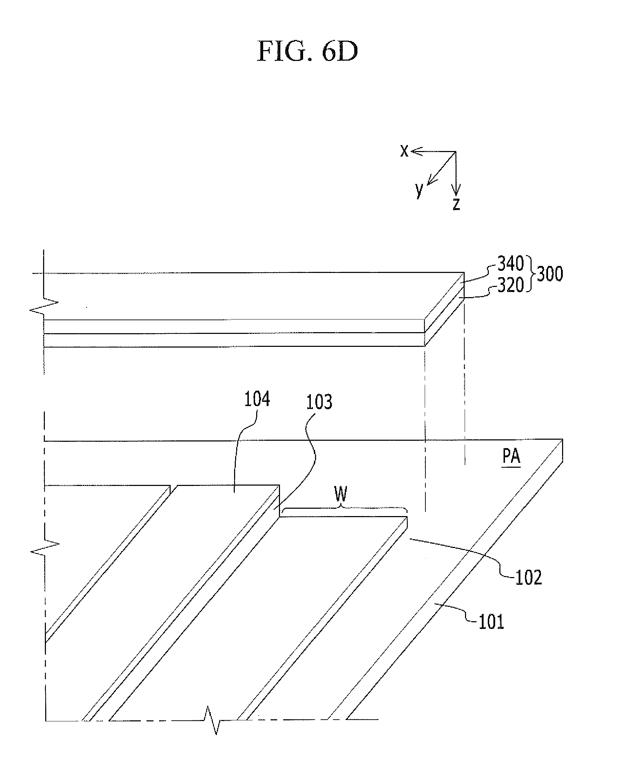

As shown in FIG. 6D, a bus bar 300 is formed in the periphery area (PA) of the substrate 101 (S106). The bus bar 300 is formed in a direction (x-axis direction of FIG. 6D) that is perpendicular to the length direction of the photoelectric converting cell 100. The bus bar metal layer 340 is adhered to the substrate 101 by using the insulating adhesive layer 320. An opposite first end of the bus bar 300 not shown in FIG. 6D can be electrically connected to a junction box (not shown) disposed outside the photoelectric converting cell module 10.

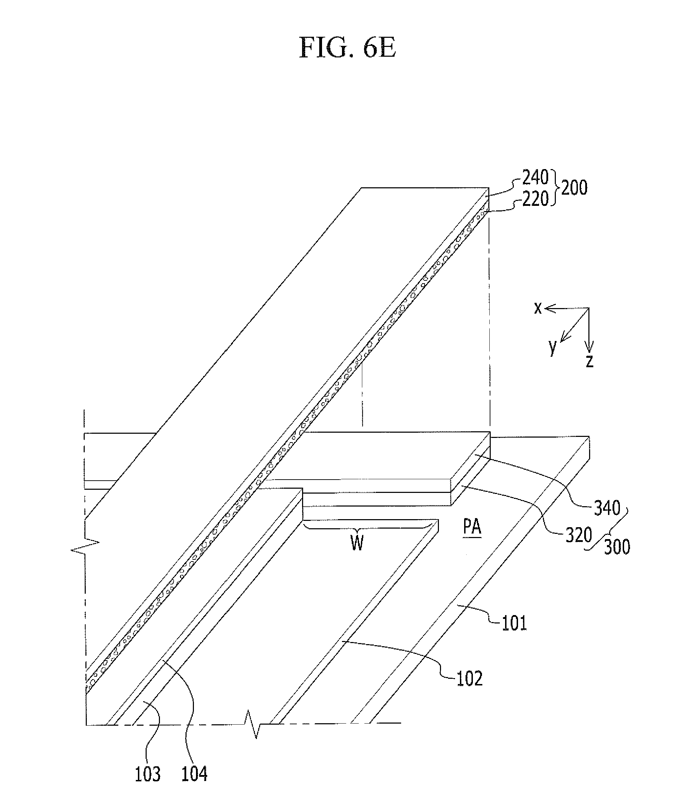

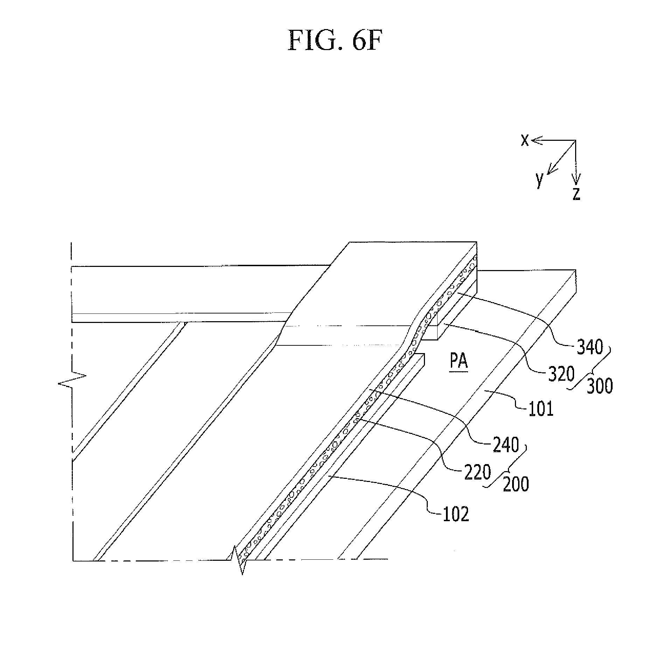

As shown in FIG. 6E and FIG. 6F, an interconnect wiring 200 is formed over the wiring connector (W) of the rear electrode layer 102 and the top of the bus bar 300 (S108). The interconnect wiring 200 is formed in a direction (y-axis direction of FIG. 6E) that is parallel with the length direction of the photoelectric converting cell 100. The conductive adhesive layer 220 is used to adhere the wiring metal layer 240 to the wiring connector (W) of the rear electrode layer 102. Also, a part that is passed through the wiring connector (W) and is further extended is adhered to the bus bar metal layer 340 of the bus bar 300. Therefore, the wiring metal layer 240 is electrically connected to the rear electrode layer 102 and the bus bar 300 through the conductive particles in the conductive adhesive layer 220. At this time, a pressure process is performed regarding the interconnect wiring 200 so as to secure a sufficient electrical connection. That is, the rear electrode 102 (or bus bar metal layer 340), the conductive particle, and the wiring metal layer 240 is contacted and electrically connected to each other by the pressure process. The pressure process is separately performed when the interconnect wiring 200 is attached, or is performed with a lamination process (described later) or by pressure of the lamination process.

In addition, if needed, a black cover layer (not shown) made of a black polyethylene terephthalate (PET) film is further adhered to the wiring metal layer 240 and the bus bar metal layer 340 so as to improve the appearance. That is, the interconnect wiring 200 with black cover layer thereon is attached to the rear electrode layer 102 and the bus bar 300, and then a tape type black cover layer is attached on the bus bar 300 and the extended portion 201 of the interconnect wiring 200, so that the black cover layer can be formed easily.

Thereafter, a cover substrate (not shown) is disposed on the photoelectric converting cell module 10, and then a sealing process and a lamination process is performed (S 110). A frame and a junction box (not shown) are assembled with the photoelectric converting cell module 10 to complete the photoelectric converting cell module 10 (S112).

According to the present embodiment, the interconnect wiring 200 and the bus bar 300 of the photoelectric converting cell module 10 is formed by adhering the metal tape so the cost is reduced and the process is simplified.

Further, the adhesive layer of the interconnect wiring 200 is formed with the conductive adhesive layer 240 and the adhesive layer of the bus bar 300 is formed with the insulating adhesive layer 340, thereby acquiring an excellent characteristic through the simple process. That is, interconnect wiring 200 can have excellent current flow without increasing contact resistance regarding the rear electrode layer 102 and the bus bar 300. In addition, generation of the leakage current by the bus bar 300 is prevented since the bus bar 300 is sufficiently insulated from the substrate 101.

While preferred embodiments have been described, it is to be understood that the invention is not limited thereto, but is intended to cover various modifications and equivalent arrangements included within the scope of the appended claims, description, and drawings.

## Claims

1. A photoelectric converting cell module comprising:
a substrate;
a plurality of photoelectric converting cells coupled in series;
interconnect wiring comprising a wiring metal layer and a conductive adhesive layer; and
a bus bar comprising a bus bar metal layer and an insulating adhesive layer, wherein:
the substrate includes an active area in which the plurality of photoelectric converting cells are formed, and a periphery area which surrounds the active area and in which the bus bar is formed;
the interconnect wiring is electrically coupled to the photoelectric converting cell formed in the outermost region of the active area and extends from the active area to the periphery area and is electrically coupled to the bus bar.

2. The photoelectric converting cell module according to Claim 1, wherein each of the plurality of photoelectric converting cells comprises a rear electrode layer, a photoelectric converting layer and a transparent electrode layer disposed in order on top of the substrate.

3. The photoelectric converting cell module according to Claim 1 or Claim 2, further comprising a wiring connector that is a partially exposed section of the rear electrode layer of the photoelectric converting cell formed in the outermost region of the active area and forms the electrical connection between the plurality of photoelectric converting cells and the interconnect wiring.

4. The photoelectric converting cell module according to Claim 2 or Claim 3, wherein:
(a) the photoelectric converting cells extend in a first direction of the substrate and are coupled in series in a second direction perpendicular to the first direction; and/or
(b) the substrate is formed from one or more of plate-type glass, ceramic, stainless steel, metal, or film-type polymers; and/or
(c) the rear electrode layer is made of a metal or alloy that adheres to the substrate, optionally the metal or alloy comprises molybdenum; and/or
(d) the photoelectric converting layer is made of one of silicon and a compound semiconductor; and/or
(e) the transparent electrode layer is formed from a metal oxide that comprises one or more of boron doped zinc oxide (BZO), zinc oxide (ZnO), indium oxide (In₂O₃) and indium tin oxide (ITO); and/or
(f) the substrate is formed with plate-type glass, ceramic, stainless steel, metal, or film-type polymers.

5. The photoelectric converting cell module according to any one of Claims 1 to 4, wherein:
(a) the wiring metal layer is a metal foil or a metal ribbon made of copper (Cu), copper (Cu)/tin (Sn), aluminum (Al), lead (Pb), silver (Ag), or an alloy thereof; and/or
(b) the thickness of the wiring metal layer is between 30 to 400µm;
and/or
(c) the interconnect wiring is adhered to the wiring connector by the conductive adhesive layer; and/or
(d) the interconnect wiring further comprises a black cover layer made of a black polyethylene terephthalate, optionally wherein the interconnect wiring is adhered to a top of the rear electrode layer exposed in the first direction of the photoelectric converting cell formed in the outermost region of the active area.

6. The photoelectric converting cell module according to any one of Claims 1 to 5, wherein the conductive adhesive layer comprises conductive particles and an adhesive in which the conductive particles are distributed.

7. The photoelectric converting cell module according to Claim 6, wherein:
(a) the conductive particles are metal particles comprising at least one of copper (Cu), silver (Ag), gold (Au), iron (Fe), nickel (Ni), lead (Pb), zinc (Zn), cobalt (Co), titanium (Ti) and magnesium (Mg) or plating particles caused by said metals; and/or
(b) the conductive particles have a diameter of from 10nm to 100,000nm; and/or
(c) the adhesive in which the conductive particles are distributed is an adhesive layer made of a resin including an acryl-based resin, an epoxy-based resin, a butyl-based resin, ethylvinyl acetate (EVA), polyvinyl butyral (PVB), silicon (Si), ionomer, or polyoxy ethylene (POE); and/or
(d) the thickness of the conductive adhesive layer is from 1µm to 500µm; and/or
(e) the conductive particles are distributed homogeneously throughout the adhesive layer.

8. The photoelectric converting cell module according to any one of Claims 1 to 7, wherein:
(a) the bus bar metal layer is a metal foil or a metal ribbon made of copper (Cu), copper (Cu)/tin (Sn), aluminum (Al), lead (Pb), silver (Ag), or an alloy thereof; and/or
(b) the insulating adhesive layer 320 is an adhesive layer made of resin including an acryl-based resin, an epoxy-based resin, a butyl-based resin, ethylvinyl acetate (EVA), polyvinyl butyral (PVB), silicon (Si), an ionomer, and polyoxy ethylene (POE); and/or
(c) the insulating adhesive layer is substantially thicker than 1µm and is thinner than 500µm; and/or
(d) the bus bar metal layer is adhered to the periphery area (PA) of the substrate by the insulating adhesive layer; and/or
(e) the bus bar is formed in a second direction that is perpendicular to the length direction of the plurality of photoelectric converting cells.

9. The photoelectric converting cell module according to any one of Claims 1 to 8, wherein the interconnect wiring further comprises an extended portion and the bus bar further comprises an overlapped portion formed on a first end of the bus bar, such that the extended portion of the interconnect wiring overlaps and is attached to the overlapped portion of the bus bar.

10. The photoelectric converting cell module according to Claim 9, wherein the insulating adhesive layer, the bus bar metal layer, the conductive adhesive layer, and the wiring metal layer are sequentially stacked on a region in which the extended portion of the interconnect wiring is overlapped with the overlapped portion of the bus bar.

11. A method of manufacturing a photoelectric converting cell module according to any one of Claims 1 to 10, comprising the steps of:
(a) forming a plurality of photoelectric converting cells coupled in series on a substrate;
(b) selectively etching the plurality of photoelectric converting cells on the substrate to generate a wiring connector;
(c) deleting the edges of the plurality of photoelectric converting cells are deleted along at least one edge of the substrate to expose the substrate and generate an active area and a periphery area on said substrate, wherein the periphery area corresponds to the exposed substrate and the active area comprises the plurality of photoelectric converting cells and the wiring connector;
(d) forming a bus bar on the periphery area of the substrate; and
(e) electrically connecting an interconnect wiring to the wiring connector of the rear electrode layer and to the bus bar.

12. A method of manufacturing a photoelectric converting cell module according to Claim 11, wherein:
(i) in step (a) a rear electrode layer, a photoelectric converting layer, and a transparent electrode layer are sequentially stacked on a substrate and patterned to form the plurality of photoelectric converting cells coupled in series; and/or
(ii) in step (b) the photoelectric converting layer and the transparent electrode layer of the photoelectric converting cell formed in the outermost region are selectively etched to expose the rear electrode layer, at least part of said exposed rear electrode layer forming the wiring connector, optionally wherein the etching process is performed by at least one of the laser scribing method, mechanical deletion, wet etching, or paste etching; and/or
(iii) in step (c) the edges of the rear electrode layer, the photoelectric converting layer, and the transparent electrode layer of the plurality of photoelectric converting cells are deleted along at least one edge of the substrate to expose the substrate and generate an active area and a periphery area on said substrate, wherein the periphery area corresponds to the exposed substrate and the active area comprises the plurality of photoelectric converting cells and the wiring connector disposed on the substrate, optionally wherein the deletion process is performed by at least one of the laser scribing method, mechanical deletion, wet etching, or paste etching.

13. A method of manufacturing a photoelectric converting cell module according to Claim 11 or 12, wherein in step (d):
(i) the bus bar is formed on the periphery area of the substrate in a direction that is perpendicular to the length direction of the plurality of photoelectric converting cells; and/or
(ii) the bus bar comprises a bus bar metal layer and an insulating adhesive layer as described in any of Claims 1 to 10, such that the bus bar metal layer is adhered to the substrate by using the insulating adhesive layer.

14. A method of manufacturing a photoelectric converting cell module according to any one of Claims 11 to 13, wherein in step (e):
(i) the interconnect wiring is formed in a direction that is parallel with the length direction of the plurality of photoelectric converting cells; and/or
(ii) the interconnect wiring comprises a wiring metal layer and a conductive adhesive layer as described in any of Claims 1 to 10 and wherein the conductive adhesive layer is used to adhere the wiring metal layer to the wiring connector of the rear electrode layer and an extended portion thereof is adhered to the bus bar metal layer of the bus bar; and/or
(iii) after application of the interconnect wiring a pressure process is performed so as to secure an electrical connection.

15. The method of any one of Claims 11 to 14, further comprising:
(A) a step (f) comprising the addition of a black cover layer made of polyethylene terephthalate (PET) is adhered to the wiring metal layer 240 and the bus bar metal layer; and/or
(B) a step (g) comprising disposing a cover substrate on the photoelectric converting cell module, and then a sealing process and a lamination process is performed; and/or
(C) a step (h) comprising assembling a frame and a junction box with the photoelectric converting cell module to complete the photoelectric converting cell module.
